(19) **Europäisches Patentamt European Patent Office Office européen des brevets**

(11) **EP 3 631 482 B1**

(12) **EUROPÄISCHE PATENTSCHRIFT**

(45) Veröffentlichungstag und Bekanntmachung des Hinweises auf die Patenterteilung:
**25.03.2026 Patentblatt 2026/13**

(21) Anmeldenummer: **18728820.4**

(22) Anmeldetag: **23.05.2018**

(51) Internationale Patentklassifikation (IPC):
***G01R 31/08*** (2020.01)

(52) Gemeinsame Patentklassifikation (CPC):
**G01R 31/088;** G01R 31/085

(86) Internationale Anmeldenummer:
**PCT/EP2018/063556**

(87) Internationale Veröffentlichungsnummer:
**WO 2018/219750 (06.12.2018 Gazette 2018/49)**

(54) **ÜBERPRÜFUNG EINES ENERGIEÜBERTRAGUNGSNETZES UND LOKALISIERUNG EINER FEHLERSTELLE IN EINEM ENERGIEÜBERTRAGUNGSKABEL**

TESTING AN ENERGY TRANSMISSION NETWORK AND LOCALIZING A FAULT LOCATION IN AN ENERGY TRANSMISSION CABLE

VÉRIFICATION D'UN RÉSEAU DE TRANSMISSION D'ÉNERGIE ET LOCALISATION D'UN EMPLACEMENT DE DÉFAUT DANS UN CÂBLE DE TRANSMISSION D'ÉNERGIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **02.06.2017 AT 504662017**

(43) Veröffentlichungstag der Anmeldung:
**08.04.2020 Patentblatt 2020/15**

(73) Patentinhaber: **Omicron Energy Solutions GmbH 12099 Berlin (DE)**

(72) Erfinder:
• **EMANUEL, Harald**
  **10179 Berlin (DE)**
• **COBET, Andreas**
  **12203 Berlin (DE)**
• **KÜHLING, David**
  **12099 Berlin (DE)**
• **MÖLLER, Jan**
  **10365 Berlin (DE)**

(74) Vertreter: **Kraus & Lederer PartGmbB Thomas-Wimmer-Ring 15 80539 München (DE)**

(56) Entgegenhaltungen:
CN-A- 104 049 179     DE-A1- 102014 222 662
US-A1- 2005 212 526     US-A1- 2008 059 671
US-A1- 2009 289 637     US-A1- 2014 074 414

• IOAN IBARBURAS ET AL: "Detecting The Fault Location Using Traveling Wave", 18 May 2015 (2015-05-18), XP055501801, Retrieved from the Internet <URL:https://ie.utcluj.ro/files/acta/2015/Number3/MPS2015_Barburas.pdf> [retrieved on 20180823]

**Beschreibung**

Die vorliegende Erfindung betrifft zum einen die Überprüfung eines Energieübertragungsnetzes auf Fehler (z.B. auf Fehler in der Isolierung) und zum anderen die Lokalisierung eines solchen Fehlers, indem eine Fehlerstelle in einem Energieübertragungskabel lokalisiert wird.

In "Detecting The Fault Location Using Traveling Wave" von I.V. Barburas u.a., 6th International Conference on Modern Power Systems, 18-21 Mai 2015, Seiten 23 bis 26 wird eine "Traveling Wave"-Technik zur Fehlerlokalisierung beschrieben, bei der die Ankunftszeiten einer sich vom Fehlerort ausbreitenden Welle in beide Richtungen einer Übertragungsleitung zur Lokalisierung des Fehlerorts eingesetzt werden.

CN 104 049 179 A offenbart ein Erfassen von "Traveling Wave"-Informationen mit mehreren Überwachungsterminals, die auf einer Stromübertragungsleitung verteilt sind. Abhängig von diesen Informationen wird ein Fehlerabschnitt bestimmt, in dem sich die Fehlerstelle befindet.

DE 10 2014 222 662 A1 betrifft die Datenanreicherung von Messdatensätzen eines Niederspannungsnetzes. Dabei werden asynchron von mehreren Netzknoten eintreffende Messdatensätze in einer zeitlichen Reihenfolge pro Netzknoten gespeichert. Dadurch können einfach jene Messdaten selektiert werden, die in einem bestimmten Zeitraum angefallen sind.

US 2009/289637 A1 beschreibt die Bestimmung einer Impedanz einer Spannungsleitung.

Die US 2014/074414 A1 offenbart Systeme und Verfahren zur Berechnung eines Fehlerortes in einem elektrischen Energieversorgungssystem auf der Grundlage einer Wanderwelle, die durch einen elektrischen Fehler in dem elektrischen Energieversorgungssystem erzeugt wird. Dabei erfasst eine intelligente elektronische Einrichtung die durch den elektrischen Fehler verursachte transiente Wanderwelle. Eine erste Zeit, die mit dieser ersten Wanderwelle verbunden ist, wird ermittelt. Die intelligente elektronische Einrichtung empfängt eine zweite Zeit, die mit einem zweiten Wanderwellenwert der Wanderwelle verbunden ist, der von einer entfernten intelligenten elektronischen Einrichtung erfasst wurde.

Zur Überprüfung eines Energieübertragungsnetzes und insbesondere zur Lokalisierung einer Fehlerstelle wird nach dem Stand der Technik nur an einem Messpunkt des Energieübertragungsnetzes ein Ereignis (z.B. die Auswirkungen einer Teilentladung) erfasst. Indem der Zeitpunkt, zu welchem dieses Ereignis an dem Messpunkt auftritt, und ein weiterer Zeitpunkt, zu welchem eine Reflektion dieses Ereignisses an dem Messpunkt auftritt, bestimmt werden, kann dann die Fehlerstelle lokalisiert werden.

Diese bekannte Lokalisierung der Fehlerstelle in einem Energieübertragungsnetz oder genauer in einem Energieübertragungskabel des Energieübertragungsnetzes ist allerdings recht ungenau. Daher stellt sich die vorliegende Erfindung die Aufgabe, die Lokalisierung einer Fehlerstelle in einem Energieübertragungskabel gegenüber dem Stand der Technik zu verbessern. Da die Lösung dieser Aufgabe auf einer möglichst genauen Bestimmung eines Zeitpunkts basiert, zu welchem ein bestimmtes Ereignis an einem bestimmten Messpunkt des Energieübertragungsnetzes auftritt, umfasst die erfindungsgemäße Aufgabe zusätzlich eine möglichst genaue Bestimmung dieses Zeitpunkts.

Erfindungsgemäß wird diese Aufgabe, durch ein Verfahren zur Überprüfung eines Energieübertragungsnetzes nach Anspruch 1 sowie durch ein System nach Anspruch 6 gelöst. Die abhängigen Ansprüche beschreiben vorteilhafte und bevorzugte Ausführungsformen der vorliegenden Erfindung.

Gemäß einer erfindungsgemäßen Ausführungsform der vorliegenden Erfindung wird ein Verfahren zur Lokalisierung einer Fehlerstelle in einem Energieübertragungskabel bereitgestellt, wobei das erfindungsgemäße Verfahren folgende Schritte umfasst:

- Erfassen eines ersten Zeitpunkts, zu welchem ein bestimmter Teilentladungspuls, der an der Fehlerstelle entsteht, in dem Energieübertragungskabel an einem ersten Messpunkt, welcher an einem Ende des Energieübertragungskabels angeordnet ist, erfasst wird. Der erste Zeitpunkt definiert demnach, wann sich die Auswirkungen einer bestimmten an der Fehlerstelle entstehenden Teilentladung über das Energieübertragungskabel bis zu dem ersten Messpunkt ausgebreitet haben. Die Ausbreitung der Auswirkungen der Teilentladung umfasst dabei insbesondere eine Ladungsdämpfung und benötigt Zeit, um sich entlang des Energieübertragungskabels auszubreiten.

- Erfassen eines zweiten Zeitpunkts, zu welchem der bestimmte Teilentladungspuls in dem Energieübertragungskabel an einem zweiten Messpunkt, welcher an dem anderen Ende des Energieübertragungskabels angeordnet ist, erfasst wird. In gleicher Weise wie der erste Zeitpunkt definiert der zweite Zeitpunkt, wann sich die Auswirkungen des bestimmten Teilentladungspulses bzw. der bestimmten Teilentladung über das Energieübertragungskabel bis zu dem zweiten Messpunkt ausgebreitet haben.

- Bestimmen der Fehlerstelle entlang des Energieübertragungskabels, an welcher der bestimmte Teilentladungspuls bzw. die bestimmte Teilentladung erzeugt wurde, in Abhängigkeit von dem ersten und dem zweiten Zeitpunkt. Wie später noch genau erläutert wird, kann insbesondere unter Kenntnis der Länge des Energieübertragungskabels und der Ausbreitungsgeschwindigkeit des Teilentladungspulses auf dem Energieübertragungskabel die Fehlerstelle als Abstand von dem ersten Messpunkt oder zweiten Messpunkt recht genau bestimmt werden.

- Bestimmen eines dritten und eines vierten Messpunkts aus einer Menge von in dem oder entlang des Energieübertragungskabels angeordneten Messpunkten. Der dritte und der vierte Messpunkt werden dabei derart bestimmt, dass sie einen Abschnitt des Energieübertragungskabels begrenzen, in welchem die Fehlerstelle, deren Lage im vorherigen Schritt bestimmt wurde, liegt und sich kein weiterer der Messpunkte befindet. In diesem Schritt werden demnach mit dem dritten und vierten Messpunkt zwei Messpunkte aus der Menge der Messpunkte bestimmt, zwischen denen die Fehlerstelle liegt und welche den geringsten möglichen Abstand unter allen Messpunkten zu der Fehlerstelle aufweisen.

- Erfassen eines dritten Zeitpunkts, zu welchem ein weiterer bestimmter Teilentladungspuls in dem Energieübertragungskabel an dem dritten Messpunkt erfasst wird.

- Erfassen eines vierten Zeitpunkts, zu welchem der weitere bestimmte Teilentladungspuls an dem vierten Messpunkt erfasst wird. Diese beiden letzten Schritte sind den beiden ersten Schritten des erfindungsgemäßen Verfahrens sehr ähnlich, nur dass bei den letzten Schritten die Messpunkte (d.h. der dritte und der vierte Messpunkt) dichter an der Fehlerstelle angeordnet sind als bei den beiden ersten Schritten des erfindungsgemäßen Verfahrens.

- Korrigieren der bestimmten Fehlerstelle abhängig von dem dritten und dem vierten Zeitpunkt. Anhand des dritten und des vierten Zeitpunkts kann die Lage der Fehlerstelle besser bestimmt werden, als anhand des ersten und des zweiten Zeitpunkts, da sich der dritte und der vierte Messpunkt dichter an der Fehlerstelle befinden, als der erste und der zweite Messpunkt. Unter dem Korrigieren der bestimmten Fehlerstelle wird dabei insbesondere verstanden, dass die Lage der bestimmten Fehlerstelle genauer bestimmt wird.

Indem erfindungsgemäß die Bestimmung der Lage der Fehlerstelle oder die Lokalisierung der Fehlerstelle anhand von zwei Messpunkten, welche jeweils bildlich gesprochen rechts und links von der Fehlerstelle in dem Energieübertragungskabel angeordnet sind, erfolgt, kann die Lokalisierung der Fehlerstelle wesentlich genauer vorgenommen werden, als nach dem Stand der Technik, bei welchem mit nur einem Messpunkt und der Reflektion des Teilentladungspulses gearbeitet wird. Darüber hinaus erfolgt die Lokalisierung der Fehlerstelle vorteilhafterweise quasi zweistufig. In einer ersten Stufe wird die Fehlerstelle grob lokalisiert, um anhand dieser groben Lokalisierung zwei Messpunkte (d.h. den dritten und den vierten Messpunkt) optimal (d.h. möglichst dicht an der Fehlerstelle) auszuwählen. Anhand dieser optimal ausgewählten zwei Messpunkte kann dann in der zweiten Stufe die Lage der Fehlerstelle vorteilhafterweise sehr genau bestimmt werden.

Unter einem Messpunkt wird dabei insbesondere eine Kabelverbindung (Joint) oder ein Kabelabschluss (Termination) verstanden.

Das Erfassen bzw. Messen der Teilentladung an einem bestimmten Messpunkt erfolgt dabei insbesondere auf statistische Art und Weise. Das Erfassen bzw. Messen wird dabei anhand von vielen Ereignissen (Teilentladungen) wiederholt vorgenommen, um Fehler in der Korrelation zu vermeiden.

Das Erfassen eines Zeitpunkts, zu welchem ein bestimmter Teilentladungspuls in dem Energieübertragungskabel an einem bestimmten Messpunkt erfasst wird, setzt voraus, dass an dem bestimmten Messpunkt zwischen dem bestimmten Teilentladungspuls und einem anderen Teilentladungspuls unterschieden werden kann. Anders ausgedrückt setzt die vorliegende Erfindung voraus, dass die Auswirkungen derselben Teilentladung an der Fehlerstelle an dem ersten (dritten) und zweiten (vierten) Messpunkt erfasst werden, um anhand der Zeitpunkte den Ort der Fehlerstelle lokalisieren zu können.

Die Unterscheidung zwischen Teilentladungspulsen kann beispielsweise anhand von Eigenschaften der zu vergleichenden Teilentladungspulse erfolgen. Beispielsweise kann der jeweils an dem bestimmten Messpunkt erfasste Teilentladungspuls abhängig von einem auf dem Energieübertragungskabel übertragenen Energieimpuls und anhand eines Zeitpunktes, zu welchem der Teilentladungspuls beispielsweise bestimmte Eigenschaften aufweist, analysiert werden, um dadurch den bestimmten Teilentladungspuls von anderen Teilentladungspulsen unterscheiden zu können. Dieses Vorgehen zum Erfassen eines Zeitpunkts, zu welchem ein bestimmter Teilentladungspuls in dem Energieübertragungskabel an einem bestimmten Messpunkt erfasst wird, ist nach dem Stand der Technik bekannt, weshalb es hier nicht weiter vertieft wird.

Gemäß einer bevorzugten erfindungsgemäßen Ausführungsform wird die Fehlerstelle als Abstand $l_f$ von dem dritten Messpunkt anhand der folgenden Gleichung (1) bestimmt:

$$l_f = \frac{v_{PD}}{2}(t_3 - t_4) + \frac{l}{2} \qquad (1)$$

Dabei entspricht $t_3$ dem dritten Zeitpunkt, $t_4$ dem vierten Zeitpunkt, $v_{PD}$ der Ausbreitungsgeschwindigkeit des Teilentladungspulses (d.h. der Auswirkungen der Teilentladung) entlang des Energieübertragungskabels und I der Länge des Abschnitts des Energieübertragungskabels, welcher von dem dritten und vierten Messpunkt begrenzt wird.

Es sei angemerkt, dass die Gleichung (1) auch eingesetzt werden kann, um die Fehlerstelle abhängig von dem ersten und dem zweiten Zeitpunkt zu bestimmen. In diesem Fall entspricht $t_3$ dem ersten Zeitpunkt, $t_4$ dem zweiten Zeitpunkt I der Länge des Energieübertragungskabels, welches von dem ersten Messpunkt bzw. dem einen Ende bis zu dem zweiten Messpunkt bzw. dem anderen Ende des Energieübertragungskabels verläuft. Der Abstand $l_f$ definiert in diesem Fall den Abstand der Fehlerstelle von dem ersten Messpunkt bzw. dem einen Ende des Energieübertragungskabels.

Darüber hinaus ist es erfindungsgemäß möglich, dass zum ersten, zweiten, dritten und vierten Zeitpunkt am ersten, zweiten, dritten bzw. vierten Messpunkt jeweils derselbe Teilentladungspuls bzw. die Auswirkungen derselben Teilentladung, wenn auch mit unterschiedlicher Dämpfung, erfasst werden. In diesem Fall entspricht der bestimmte Teilentladungspuls demnach dem weiteren bestimmten Teilentladungspuls.

Beispielsweise können alle Messpunkte so ausgelegt sein, dass sie jeweils die Zeitpunkte bestimmen und abspeichern, zu welchen sie Teilentladungspulse erfassen. In einem anschließenden Auswertungsschritt kann dann für denselben Teilentladungspuls ermittelt werden, wann dieser Teilentladungspuls an dem ersten, zweiten, dritten und vierten Messpunkt erfasst wurde, woraus dann die Lage der Fehlerstelle ermittelt werden kann, wie es vorab beschrieben ist.

Gemäß einer weiteren bevorzugten erfindungsgemäßen Ausführungsform entspricht der erste, der zweite, der dritte und der vierte Zeitpunkt jeweils einem entsprechenden Zeitpunkt, zu welchem eine Information über den jeweiligen Teilentladungspuls von Steuermitteln erfasst wird. Gemäß der weiteren Ausführungsform wird zusätzlich eine jeweilige Zeitverzögerung bestimmt, welche sich durch die Übertragung der jeweiligen Information von dem entsprechenden Messpunkt zu den Steuermitteln ergibt. Der jeweilige Zeitpunkt wird dann um die entsprechende Zeitverzögerung korrigiert. Die Bestimmung der Zeitverzögerung erfolgt dabei durch das erfindungsgemäße Verfahren zur Überprüfung eines Energieübertragungsnetzes.

Gemäß dieser weiteren Ausführungsform überträgt eine erste, zweite, dritte und vierte Messeinheit, welche mit dem ersten, zweiten, dritten bzw. vierten Messpunkt verbunden ist, die entsprechende Information über den entsprechenden Teilentladungspuls an die Steuermittel, sobald die jeweilige Messeinheit an dem zugehörigen Messpunkt den entsprechenden Teilentladungspuls erfasst hat. Die Steuermittel bestimmen und korrigieren die Lage der Fehlerstelle dann abhängig von dem ersten, zweiten, dritten und vierten Zeitpunkt, zu welchem die jeweilige Information die Steuermittel erreicht, wobei dabei die jeweilige Zeitverzögerung, welche sich durch die Übertragung der jeweilige Information von dem entsprechenden Messpunkt bzw. von der entsprechenden Messeinheit zu den Steuermitteln ergibt, berücksichtigt wird.

Auf welche Art und Weise die jeweilige Zeitverzögerung für die Übertragung der jeweiligen Information von der entsprechenden Messeinheit zu den Steuermitteln bestimmt wird, wird im Folgenden noch genauer dargelegt.

Im Rahmen der vorliegenden Erfindung wird ein Verfahren zur Überprüfung eines Energieübertragungsnetzes bereitgestellt. Dabei umfasst das Verfahren zur Überprüfung des Energieübertragungsnetzes folgende Schritte:

- Erfassen eines Ereignisses (z.B. eines Teilentladungspulses oder der Auswirkungen einer Teilentladung) an einem Messpunkt oder einer Messeinheit, welche mit dem Messpunkt verbunden ist.

- Übertragen einer Information über das Ereignis von dem Messpunkt an Steuermittel. Sobald insbesondere die mit dem Messpunkt verbundene Messeinheit das Ereignis erfasst, wird eine entsprechende Information an die Steuermittel übertragen.

- Erfassen eines Zeitpunkts, zu welchen die Information über das Ereignis von den Steuermitteln erfasst wird. Der Zeitpunkt definiert somit, wann die Information über das Ereignis die Steuermittel erreicht.

- Bestimmen einer Zeitverzögerung, welche sich durch eine Übertragung der Information von dem Messpunkt oder der mit dem Messpunkt verbundenen Messeinheit zu den Steuermitteln ergibt.

- Korrigieren des Zeitpunktes abhängig von der bestimmten Zeitverzögerung. Durch die Korrektur des Zeitpunktes um die Zeitverzögerung spiegelt der Zeitpunkt vorteilhafterweise genau den Zeitpunkt wieder, zu welchem das Ereignis am jeweiligen Messpunkt erfasst wurde.

- Überprüfen des Energieübertragungsnetzes in Abhängigkeit von dem Ereignis und dem korrigierten Zeitpunkt.

Da der korrigierte Zeitpunkt quasi dem Zeitpunkt entspricht, zu welchem das zu erfassende Ereignis an dem jeweiligen Messpunkt erfasst wurde, kann die Überprüfung des Energieübertragungsnetzes vorteilhafterweise basierend auf diesem Zeitpunkt ausgeführt werden. Dadurch können insbesondere Überprüfungen des Energieübertragungsnetzes genauer durchgeführt werden, bei welchen der jeweilige Zeitpunkt, zu welchem ein Ereignis an mehreren verschiedenen Messpunkten auftritt, eine Rolle spielt. Gerade wenn mehrere Messpunkte unterschiedlich weit von den Steuermitteln entfernt sind, spielt die Übertragungszeit von den jeweiligen Messpunkten oder Messeinheiten, welche mit den jeweiligen Messpunkten verbunden sind, eine Rolle, um den zeitlichen Abstand zwischen den Zeitpunkten zu bestimmen, zu welchen dasselbe Ereignis oder die Auswirkungen desselben Ereignisses an den jeweiligen Messpunkten aufgetreten ist. Durch die erfindungsgemäße Berücksichtigung der Zeitverzögerung können die Zeitpunkte, zu welchen dasselbe Ereignis oder die Auswirkungen desselben Ereignisses an den jeweiligen Messpunkten, aufgetreten ist, im Vergleich zum Stand der Technik genauer festgelegt werden, wodurch die darauf basierende Überprüfung des Energieübertragungsnetzes ebenfalls genauer ausgeführt werden kann.

Gemäß des Verfahrens zur Überprüfung des Energieübertragungsnetzes wird die Information über das Ereignis von dem Messpunkt (oder von der mit dem Messpunkt verbundenen Messeinheit) über mindestens einen weiteren Messpunkt (oder über mindestens eine weitere mit einem Messpunkt verbundene Messeinheit) zu den Steuermitteln übertragen. Dabei ist der Messpunkt (oder die Messeinheit), der mindestens eine weitere Messpunkt (oder die mindestens eine weitere Messeinheit) und die Steuermittel über Leitungen miteinander verbunden, über welche die Information übertragen wird. Die Bestimmung der Zeitverzögerung umfasst zum einen eine Bestimmung einer Laufzeit der Information über die Leitungen und zum anderen eine Bestimmung einer Verarbeitungszeit des jeweiligen Messpunkts (oder der jeweiligen mit dem Messpunkt verbundenen Messeinheit), um die Information an dem jeweiligen Messpunkt (Messeinheit) zu erfassen und weiterzuleiten.

Bei dieser Ausführungsform sind die Messpunkte oder Messeinheiten beispielsweise über die Daisy-Chain-Technik miteinander verbunden. Eine Information wird dabei von der aussendenden Messeinheit an die nächste in Richtung der Steuermittel liegende Messeinheit weitergeleitet, welche dann ihrerseits die Information an die nächste in Richtung der Steuermittel liegende Messeinheit weiterleitet, usw., bis die Information schließlich die Steuermittel erreicht.

Wenn man sich den Messpunkt (Messeinheit), an welchem das Ereignis erfasst wird, den mindestens einen weiteren Messpunkt (Messeinheit) und die Steuermittel jeweils als eine Einheit vorstellt, welche über die Leitungen in der Daisy-Chain-Technik verbunden sind, kann die Zeitverzögerung $\Delta t$ durch folgende Gleichung (2) berechnet werden.

$$\Delta t = \sum_{i=0}^{x} \frac{(RXBW_i - RXFWi_i)}{2} - \frac{(TXBW_{i+1} - TXFW_{i+1})}{2} \qquad (2)$$

Dabei entspricht RXBWj dem Zeitpunkt, zu dem ein bestimmtes Datenpaket an der j-ten Einheit in einer Rückwärtsrichtung empfangen wird. RXFWj entspricht dem Zeitpunkt, zu dem das bestimmte Datenpaket an der j-ten Einheit in einer Vorwärtsrichtung empfangen wird. TXBWj entspricht dem Zeitpunkt, zu dem das bestimmte Datenpaket an der j-ten Einheit in der Rückwärtsrichtung gesendet wird. TXFWj entspricht dem Zeitpunkt, zu dem das bestimmte Datenpaket an der j-ten Einheit in der Vorwärtsrichtung gesendet wird. x entspricht der Anzahl der weiteren Messpunkte (Messeinheiten), welche zwischen den Steuermitteln und dem Messpunkt (Messeinheit), an welchem das Ereignis erfasst wurde, liegen. Die Steuermittel ($E_0$) entsprechen der 0-ten Einheit, und der Messpunkt entspricht der ‚x+1'-ten Einheit ($E_1$-$E_6$).

Durch die Kombination des Verfahrens zur Lokalisierung einer Fehlerstelle mit dem Verfahren zur Überprüfung eines Energieübertragungsnetzes wird bei der Erfassung des ersten, zweiten, dritten oder vierten Zeitpunkts die Zeitverzögerung, welche sich durch die Übertragung der Information über den entsprechenden Teilentladungspuls von dem jeweiligen Messpunkt zu den Steuermitteln ergibt, berücksichtigt, wodurch die Erfassung bzw. Bestimmung des jeweiligen Zeitpunkts, zu welchem der Teilentladungspuls an dem entsprechenden Messpunkt erfasst wurde, wesentlich genauer durchgeführt werden kann.

Gemäß einer erfindungsgemäßen Ausführungsform wird auch ein System zur Lokalisierung einer Fehlerstelle in einem Energieübertragungskabel bereitgestellt. Dabei umfasst das erfindungsgemäße System Steuermittel und mehrere Messeinheiten. Eine erste dieser Messeinheiten ist mit einem ersten Messpunkt, welcher an einem Ende des Energieübertragungskabels angeordnet ist, verbunden, während eine zweite dieser Messeinheiten mit einem zweiten Messpunkt, welcher an dem anderen Ende des Energieübertragungskabels angeordnet ist, verbunden ist. Jede Messeinheit ist ausgestaltet, um jeweils einen Teilentladungspuls an dem mit der jeweiligen Messeinheit verbundenen Messpunkt in dem Energieübertragungskabel zu erfassen. Das System ist ausgestaltet, um mittels der ersten Messeinheit einen ersten Zeitpunkt zu erfassen, zu welchen ein bestimmter Teilentladungspuls an dem ersten Messpunkt von der erst Messeinheit erfasst wird, und um mittels der zweiten Messeinheit einen zweiten Zeitpunkt zu erfassen, zu welchem der bestimmte Teilentladungspuls an dem zweiten Messpunkt von der zweiten Messeinheit erfasst wird. Das System ist darüber hinaus ausgestaltet, um mittels der Steuermittel abhängig von dem ersten und dem zweiten Zeitpunkt eine Fehlerstelle entlang des Energieübertragungskabels zu bestimmen, an welcher der bestimmte Teilentladungspuls erzeugt wurde. Mittels der Steuermittel bestimmt das System dann einen dritten Messpunkt und einen vierten Messpunkt derart, dass der dritte und der vierte Messpunkt einen Abschnitt des Energieübertragungskabels begrenzen, in welchem die Fehlerstelle liegt und sich kein weiterer Messpunkt befindet, welcher mit einer der Messeinheiten verbunden ist. Mit einer dritten Messeinheit, welche mit dem dritten Messpunkt verbunden ist, erfasst das System einen dritten Zeitpunkt, zu welchem ein weiterer bestimmter Teilentladungspuls an dem dritten Messpunkt von der dritten Messeinheit erfasst wird, und mit einer vierten Messeinheit, welche mit dem vierten Messpunkt verbunden ist, erfasst das System einen vierten Zeitpunkt, zu welchem der weitere bestimmte Teilentladungspuls an dem vierten Messpunkt von der vierten Messeinheit erfasst wird. Schließlich korrigiert das System mittels der Steuermittel abhängig von dem dritten und dem vierten Zeitpunkt die bestimmte Fehlerstelle. Dieses System ist mit dem erfindungsgemä-ßen System zur Überprüfung eines Energieübertragungsnetzes, das im Folgenden beschrieben wird, kombiniert.

Schließlich wird im Rahmen der vorliegenden Erfindung ein System zur Überprüfung eines Energieübertragungsnetzes bereitgestellt, welches ebenfalls Steuermittel und mehrere Messeinheiten umfasst. Dabei ist jede dieser Messeinheiten mit einem jeweiligen Messpunkt innerhalb des Energieübertragungsnetzes verbunden. Jede Messeinheit ist ausgestaltet, um ein Ereignis an dem jeweiligen Messpunkt zu erfassen und um eine Information über dieses Ereignis an die Steuermittel weiterzuleiten. Die Steuermittel sind ausgestaltet, um die Information von den Messeinheiten zu erfassen und um einen Zeitpunkt zu erfassen, zu welchem die Information über das Ereignis von den Steuermitteln erfasst wird. Das System ist ausgestaltet, eine Zeitverzögerung zu bestimmen, welche sich durch eine Übertragung der Information von der Messeinheit, welche das Ereignis erfasst, zu den Steuermitteln ergibt. Die Steuermittel sind weiter ausgestaltet, um den Zeitpunkt um die Zeitverzögerung zu korrigieren, so dass der korrigierte Zeitpunkt widerspiegelt, wann das Ereignis an dem jeweiligen Messpunkt erfasst wurde. Schließlich ist das System ausgestaltet, um das Energieübertragungsnetz abhängig von dem Ereignis und dem korrigierten Zeitpunkt zu überprüfen.

Die Vorteile des erfindungsgemäßen Systems zur Überprüfung des Energieübertragungsnetzes entsprechen im Wesentlichen den Vorteilen des erfindungsgemäßen Verfahrens zur Überprüfung des Energieübertragungsnetzes, welche vorab im Detail ausgeführt sind, so dass hier auf eine Wiederholung verzichtet wird.

Durch die Kombination der beiden beschriebenen Systeme wird der jeweilige Zeitpunkt, zu welchem ein bestimmter Teilentladungspuls von der jeweiligen Messeinheit an dem zugehörigen Messpunkt erfasst wird, abhängig von der Zeitverzögerung bestimmt, welche sich durch die Übertragung der Information über den erfassten Teilentladungspuls von der jeweiligen Messeinheit an die Steuermittel ergibt.

Durch die vorliegende Erfindung kann eine Teilentladung in einem Hochspannungskabel vorteilhafterweise mit einer Genauigkeit von 2 m lokalisiert werden.

Im Folgenden wird die vorliegende Erfindung anhand bevorzugter erfindungsgemäßer Ausführungsformen mit Bezug zu den Figuren im Detail beschrieben.

In Fig. 1 ist ein Hochspannungskabel mit Messpunkten dargestellt, welche jeweils mit Messeinheiten verbunden sind, die ihrerseits mit Steuermitteln verbunden sind.

In Fig. 2 ist die erfindungsgemäße Verbindung von drei Messeinheiten mit den Steuermitteln im Detail dargestellt.

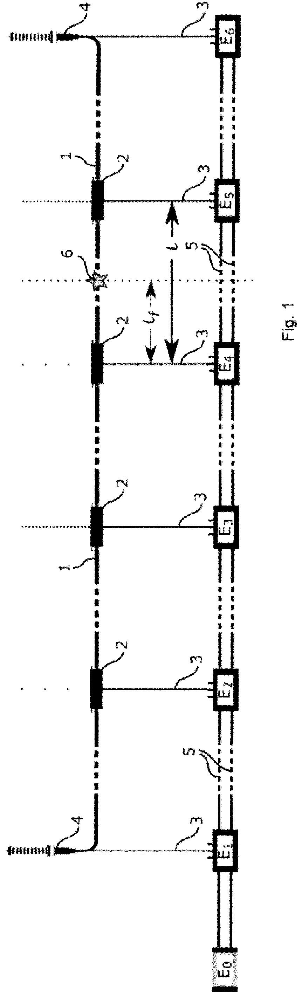

In Fig. 1 ist ein Hochspannungskabel 1 dargestellt, welches an seinen beiden Enden jeweils mit einem Kabelabschluss 4 abgeschlossen ist. Entlang des Hochspannungskabels 1 sind an verschiedenen Stellen Verbindungsstücke 2 angeordnet, durch welche das Hochspannungskabel 1 in verschiedene Abschnitte unterteilt wird. Jedes dieser Verbindungsstücke 2 und jeder der beiden Kabelabschlüsse 4 ist über ein Messkabel mit einer Messeinheit $E_1$-$E_6$ verbunden. Es sei darauf hingewiesen, dass auch deutlich mehr als sechs Messeinheiten erfindungsgemäß eingesetzt werden können.

Die Messeinheiten $E_1$ bis $E_6$ sind wiederum über Glasfaserkabel 5 in der Daisy-Chain-Technik (z.B. bis zu 20 km) miteinander verbunden, wobei die Messeinheit $E_1$ ihrerseits ebenfalls über ein Glasfaserkabel mit einer Steuerung $E_0$ verbunden ist.

Zwischen der vierten Messeinheit $E_4$ und der fünften Messeinheit $E_5$ befindet sich eine Fehlerstelle 6, an welcher Teilentladungspulse erzeugt werden. Das heißt, an der Fehlerstelle 6 im Hochspannungskabel 1 finden Teilentladungen statt, deren Auswirkungen in Form von Teilentladungspulsen, welche sich entlang des Hochspannungskabels 1 ausbreiten, an den Messeinheiten $E_1$ bis $E_6$ erfasst werden können. Der Abstand zwischen zwei entlang des Hochspannungskabels 1 benachbarten Messpunkten, welche durch ein Verbindungsstück 2 oder durch einen Kabelabschluss 4 realisiert werden, ist jeweils bekannt. Beispielhaft ist in Fig. 1 der Abstand I zwischen dem vierten Messpunkt und dem fünften Messpunkt eingezeichnet. Die Aufgabe des erfindungsgemäßen Verfahrens zur Lokalisierung einer Fehlerstelle 6 ist es, den Abstand $I_f$ zwischen einem Messpunkt 2; 4 und der Fehlerstelle 6 möglichst genau zu bestimmen.

Zur Lösung dieser Aufgabe bzw. zur Lokalisierung der Fehlerstelle 6 wird in einem ersten Schritt einer ersten Stufe ein erster Zeitpunkt bestimmt, zu welchem ein bestimmter Teilentladungspuls, welcher an der Fehlerstelle 6 erzeugt wird, an einem Ende des Hochspannungskabels 1 (am ersten Messpunkt 4), welches mit der ersten Messeinheit $E_1$

verbunden ist, erfasst wird. In einem zweiten Schritt der ersten Stufe wird in ähnlicher Weise ein zweiter Zeitpunkt bestimmt, zu welchem der bestimmte Teilentladungspuls am anderen Ende des Hochspannungskabels 1 (am sechsten Messpunkt 4), welches mit der sechsten Messeinheit $E_6$ verbunden ist, erfasst wird. Bei Kenntnis der Länge des Hochspannungskabels 1 (d.h. des Abstands zwischen dem ersten und dem sechsten Messpunkt) und der Ausbreitungsgeschwindigkeit des Teilentladungspulses entlang des Hochspannungskabels 1 kann anhand der vorab beschriebenen Gleichung (1) beispielsweise der Abstand zwischen dem ersten Messpunkt und der Fehlerstelle 6 recht genau bestimmt werden.

Anhand des derart bestimmten Abstands ist die Lage der Fehlerstelle 6 innerhalb des Hochspannungskabels 1 bekannt. Anhand der Lage können nun die beiden Messpunkte entlang des Hochspannungskabels 1 bestimmt werden, welche am dichtesten an der Fehlerstelle 6 liegen. Die beiden derart bestimmten Messpunkte (vierter und fünfter Messpunkt in Fig. 1) begrenzen einen Abschnitt des Hochspannungskabels 1, in welchem zum einen die Fehlerstelle 6 liegt und in welchem zum anderen kein einziger weiterer Messpunkt 2 liegt. Mit diesen beiden derart bestimmten Messpunkten wird die Lokalisierung der Fehlerstelle 6 in der gleichen Weise, wie es vorab beschrieben ist, wiederholt.

Dazu wird in einem ersten Schritt einer zweiten Stufe ein dritter Zeitpunkt bestimmt, zu welchem ein bestimmter Teilentladungspuls, welcher an der Fehlerstelle 6 seinen Ursprung hat, an dem einen bestimmten Messpunkt von der vierten Messeinheit $E_4$, welche mit diesem bestimmten Messpunkt verbunden ist, erfasst wird. In einem zweiten Schritt der zweiten Stufe wird ein vierter Zeitpunkt bestimmt, zu welchem der bestimmte Teilentladungspuls an dem anderen bestimmten Messpunkt von der fünften Messeinheit $E_5$, welche mit dem anderen bestimmten Messpunkt verbunden ist, erfasst wird. Wiederum anhand der Gleichung (1) kann nun der Abstand $l_f$ zwischen dem vierten Messpunkt und der Fehlerstelle 6 bei Kenntnis des Abstands l zwischen dem vierten und dem fünften Messpunkt sehr genau bestimmt werden.

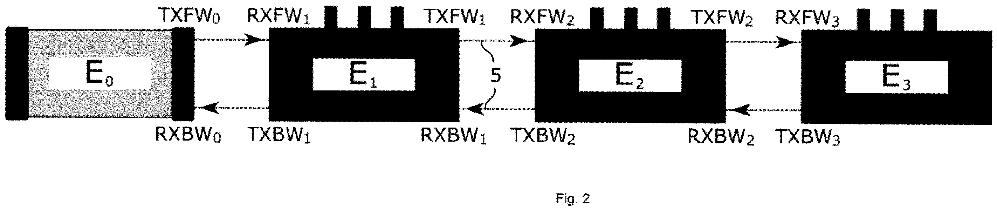

Zur Ermittlung des Zeitpunkts, zu welchem der bestimmte Teilentladungspuls an einem bestimmten Messpunkt erfasst wird, existieren erfindungsgemäß mehrere Möglichkeiten. Zum einen kann die Messeinheit, welche den Teilentladungspuls an dem an ihr angeschlossenen Messpunkt erfasst, den Zeitpunkt bestimmen, was anhand sehr genauer Zeitmesser in den Messeinheiten möglich wäre. Eine andere Möglichkeit besteht darin, dass die Messeinheit, welche den Teilentladungspuls an dem an ihr angeschlossenen Messpunkt erfasst, eine entsprechende Information, dass die Messeinheit den Teilentladungspuls erfasst hat, an die Steuerung $E_0$ überträgt, welche dann den Zeitpunkt bestimmt. Bei dieser zweiten Möglichkeit ist es allerdings vorteilhaft, die Zeitverzögerung zu berücksichtigen, welche durch die Übertragung der entsprechenden Information von der aussendenden Messeinheit zu der Steuerung $E_0$ benötigt wird. Gerade wenn die Messeinheiten $E_1$ bis $E_6$ mit der Daisy-Chain-Technik verbunden sind, wie es in Fig. 1 (und auch in Fig. 2) dargestellt ist, sollte diese Zeitverzögerung berücksichtigt werden, da diese Zeitverzögerung nicht nur durch die Laufzeit entlang des Glasfaserkabels 5, sondern auch durch die Verarbeitungszeit der zwischen der aussendenden Messeinheit und der Steuerung $E_0$ liegenden Messeinheiten beeinflusst wird.

Die Art und Weise, wie die Steuerung $E_0$ und die Messeinheiten in der Daisy-Chain-Technik miteinander verbunden sind, ist prinzipiell und mit mehr Details als in der Fig. 1 in der Fig. 2 dargestellt. Dabei sind aus darstellerischen Gründen nur drei Messeinheiten $E_1$ bis $E_3$ (anstelle der sechs Messeinheiten $E_1$ bis $E_6$ der Fig. 1) dargestellt.

Ein von der Steuerung $E_0$ ausgesendetes Datenpaket wird zum Zeitpunkt $TXFW_0$ an die erste Messeinheit $E_1$ gesendet und von der ersten Messeinheit $E_1$ zum Zeitpunkt $RXFW_1$ empfangen und zum Zeitpunkt $TXFW_1$ zur zweiten Messeinheit $E_2$ weiter gesendet, usw.. Auf dem Rückweg wird das Datenpaket zum Zeitpunkt $TXBW_3$ von der dritten Messeinheit $E_3$ an die zweite Messeinheit $E_2$ gesendet, welche das Datenpaket zum Zeitpunkt $RXBW_2$ empfängt und zum Zeitpunkt $TXBW_2$ an die erste Messeinheit $E_1$ weiter sendet, usw..

Gemäß der vorab beschriebenen Gleichung (2) werden quasi die Verzögerungszeiten $\Delta t_{VZi,i+1}$ auf dem Weg von der Messeinheit, welche den Teilentladungspuls an ihrem Messpunkt erfasst hat, zu der Steuerung $E_0$ aufsummiert. Dabei beschreibt jede Verzögerungszeit $\Delta t_{VZi,i+1}$ die Zeitspanne, welche zur Übertragung der Information von der Messeinheit i zur benachbarten Messeinheit i+1 (oder umgekehrt von der Messeinheit i+1 zur benachbarten Messeinheit i) benötigt wird. Die Verzögerungszeit $\Delta t_{VZi,i+1}$ kann dabei gemäß der folgenden Gleichung (3) bestimmt werden.

$$\Delta t_{VZ_{i,i+1}} = \frac{(RXBW_i - RXFW_i)}{2} - \frac{(TXBW_{i+1} - TXFW_{i+1})}{2} \qquad (3)$$

Der Zeitpunkt, zu welchem die Steuerung $E_0$ die Information erfasst, dass der Teilentladungspuls von der jeweiligen Messeinheit erfasst wurde, wird dann anhand der durch die Gleichung (2) berechnete Zeitverzögerung $\Delta t$ korrigiert. Das heißt, der korrigierte Zeitpunkt wird anhand der Differenz aus dem an der Steuerung $E_0$ erfassten Zeitpunkt und der Zeitverzögerung $\Delta t$ berechnet. Durch die Berücksichtigung der jeweiligen Zeitverzögerung können die Zeitpunkte an denen der jeweilige Teilentladungspuls an dem ersten Messpunkt (Messeinheit $E_1$) und an dem sechsten Messpunkt (Messeinheit $E_6$) sowie an dem vierten Messpunkt (Messeinheit $E_4$) und dem fünften Messpunkt (Messeinheit $E_5$) (siehe Fig. 1) sehr genau bestimmt werden, wodurch schließlich der Abstand $l_f$ der Fehlerstelle von dem vierten Messpunkt (Messeinheit $E_4$) mit einer sehr hohen Genauigkeit bestimmt werden kann.

BEZUGSZEICHENLISTE

| | |
|---|---|
| 1 | Hochspannungskabel |
| 2 | Verbindungsstück |
| 3 | Messkabel |
| 4 | Kabelabschluss |
| 5 | Glasfaserkabel |
| 6 | Fehlerstelle |
| $E_0$ | Einheit bzw. Steuerung |
| $E_1$ - $E_6$ | Einheit bzw. Messeinheit |
| I | Länge eines Abschnitts des Hochspannungskabels |
| $I_f$ | Abstand zwischen Messpunkt und Fehlerstelle |
| RXBWy | Empfänger in Rückwärtsrichtung ("Receiver Backward") bei Einheit y |
| RXFWy | Empfänger in Vorwärtsrichtung ("Receiver Forward") bei Einheit y |
| TXBWy | Sender in Rückwärtsrichtung ("Transmitter Backward") bei Einheit y |
| TXFWy | Sender in Vorwärtsrichtung ("Transmitter Forward") bei Einheit y |

**Patentansprüche**

**1.** Verfahren zur Überprüfung eines Energieübertragungsnetzes (1), welches folgende Schritte umfasst:

Erfassen eines Ereignisses an einem Messpunkt ($E_1$-$E_6$),
Übertragen einer Information über das Ereignis von dem Messpunkt ($E_1$-$E_6$) an Steuermittel ($E_0$), und
Erfassen eines Zeitpunktes, zu welchem die Information über das Ereignis von den Steuermitteln ($E_0$) erfasst wird,
Bestimmen einer Zeitverzögerung, welche sich durch eine Übertragung der Information von dem Messpunkt ($E_1$-$E_6$) zu den Steuermitteln ($E_0$) ergibt,
Korrigieren des Zeitpunktes um die Zeitverzögerung, und
Überprüfen des Energieübertragungsnetzes (1) abhängig von dem Ereignis und dem korrigierten Zeitpunkt, wobei die Information über das Ereignis von dem Messpunkt über mindestens einen weiteren Messpunkt zu den Steuermitteln ($E_0$) übertragen wird,
**dadurch gekennzeichnet, dass** der Messpunkt, der mindestens eine weitere Messpunkt und die Steuermittel ($E_0$) über Leitungen (5) miteinander verbunden sind, über welche die Information übertragen wird, und wobei die Bestimmung der Zeitverzögerung eine Bestimmung einer Laufzeit der Leitungen (5) und einer Verarbeitungszeit des mindestens einen weiteren Messpunkts, um die Information an dem jeweiligen Messpunkt zu erfassen und weiterzuleiten, umfasst.

**2.** Verfahren nach Anspruch 1,
**dadurch gekennzeichnet,**

**dass** der Messpunkt, der mindestens eine weitere Messpunkt und die Steuermittel ($E_0$) Einheiten entsprechen, welche mittels der Leitungen (5) in einer Daisy-Chain-Technik verbunden sind,
**dass** die Zeitverzögerung $\Delta t$ durch folgende Gleichung berechnet wird

$$\Delta t = \sum_{i=0}^{x} \frac{(RXBW_i - RXFW_i)}{2} - \frac{(TXBW_{i+1} - TXFW_{i+1})}{2},$$

wobei $RXBW_j$ dem Zeitpunkt entspricht, zu dem ein bestimmtes Datenpaket an der j-ten Einheit in einer Rückwärtsrichtung empfangen wird,
wobei $RXFW_j$ dem Zeitpunkt entspricht, zu dem das bestimmte Datenpaket an der j-ten Einheit in einer Vorwärtsrichtung empfangen wird,
wobei $TXBW_j$ dem Zeitpunkt entspricht, zu dem das bestimmte Datenpaket an der j-ten Einheit in der Rückwärtsrichtung gesendet wird,
wobei TXFWj dem Zeitpunkt entspricht, zu dem das bestimmte Datenpaket an der j-ten Einheit in der Vorwärtsrichtung gesendet wird,
wobei x der Anzahl des mindestens einen weiteren Messpunkts entspricht, und

wobei die Steuermittel ($E_0$) der 0-ten Einheit und der Messpunkt der ,x+1'-ten Einheit ($E_1$-$E_6$) entsprechen.

3. Verfahren zur Lokalisierung einer Fehlerstelle (6) in einem Energieübertragungskabel (1), welches folgende Schritte umfasst:

Erfassen eines ersten Zeitpunkts, zu welchem ein bestimmter Teilentladungspuls in dem Energieübertragungskabel (1) an einem ersten Messpunkt ($E_1$), welcher an einem Ende des Energieübertragungskabels (1) angeordnet ist, erfasst wird,

Erfassen eines zweiten Zeitpunkts, zu welchem der bestimmte Teilentladungspuls in dem Energieübertragungskabel (1) an einem zweiten Messpunkt ($E_6$), welcher an dem anderen Ende des Energieübertragungskabels (1) angeordnet ist, erfasst wird,

Bestimmen einer Fehlerstelle (6) entlang des Energieübertragungskabels (1), an welcher der bestimmte Teilentladungspuls erzeugt wurde, abhängig von dem ersten und dem zweiten Zeitpunkt,

Bestimmen eines dritten und eines vierten Messpunkts aus einer Menge von in dem Energieübertragungskabel angeordneten Messpunkten ($E_1$-$E_6$) derart, dass der dritte und der vierte Messpunkt einen Abschnitt des Energieübertragungskabels (1) begrenzen, in welchem die Fehlerstelle (6) liegt und sich kein weiterer der Messpunkte befindet,

Erfassen eines dritten Zeitpunkts, zu welchem ein weiterer bestimmter Teilentladungspuls in dem Energieübertragungskabel (1) an dem dritten Messpunkt erfasst wird,

Erfassen eines vierten Zeitpunkts, zu welchem der weitere bestimmte Teilentladungspuls an dem vierten Messpunkt erfasst wird, und

Korrigieren der bestimmten Fehlerstelle (6) abhängig von dem dritten und dem vierten Zeitpunkt,

wobei der erste Zeitpunkt, der zweite Zeitpunkt, der dritte Zeitpunkt und der vierte Zeitpunkt jeweils einem entsprechenden Zeitpunkt entsprechen, zu welchem eine Information über den entsprechenden Teilentladungs-puls von Steuermitteln ($E_0$) erfasst wird, und

wobei das Verfahren zusätzlich umfasst:

Bestimmen einer jeweiligen Zeitverzögerung, welche sich durch eine Übertragung der jeweiligen Information von dem entsprechenden Messpunkt ($E_1$-$E_6$) zu den Steuermitteln ($E_0$) ergibt, und

Korrigieren des jeweiligen Zeitpunktes um die entsprechende Zeitverzögerung,

wobei die Zeitverzögerung gemäß einem Verfahren nach einem der vorhergehenden Ansprüche bestimmt wird.

4. Verfahren nach Anspruch 3,
**dadurch gekennzeichnet,**

**dass** die Fehlerstelle (6) als Abstand $l_f$ von dem dritten Messpunkt anhand der folgenden Gleichung bestimmt wird

$$l_f = \frac{v_{PD}}{2}(t_3 - t_4) + \frac{l}{2},$$

wobei $t_3$ dem dritten Zeitpunkt, $t_4$ dem vierten Zeitpunkt, $v_{PD}$ der Ausbreitungsgeschwindigkeit des Teilentladungspulses auf dem Energieübertragungskabel (1) und I der Länge des Abschnitts entspricht.

5. Verfahren nach Anspruch 3 oder 4,
**dadurch gekennzeichnet,**
**dass** der weitere bestimmte Teilentladungspuls dem bestimmten Teilentladungspuls entspricht, so dass zu dem ersten, zweiten, dritten und vierten Zeitpunkt jeweils derselbe Teilentladungspuls an dem jeweiligen Messpunkt erfasst wird.

6. System zur Überprüfung eines Energieübertragungsnetzes (1),

wobei das System Steuermittel ($E_0$) und mehrere Messeinheiten ($E_1$-$E_6$) umfasst,
wobei jede Messeinheit ($E_1$-$E_6$), welche mit einem jeweiligen Messpunkt (2; 4) in dem Energieübertragungsnetz (1) verbunden ist, ausgestaltet ist, um ein Ereignis an dem jeweiligen Messpunkt (2; 4) zu erfassen und um eine Information über das Ereignis an die Steuermittel ($E_0$) zu übertragen, wobei die Steuermittel ($E_0$) ausgestaltet sind, um einen Zeitpunkt zu erfassen, zu welchem die Information über das Ereignis von den Steuermitteln ($E_0$)

erfasst wird,

wobei das System ausgestaltet ist, um eine Zeitverzögerung zu bestimmen, welche sich durch eine Übertragung der Information von der das Ereignis erfassenden Messeinheit zu den Steuermitteln ($E_0$) ergibt, und dass die Steuermittel ($E_0$) ausgestaltet sind, um den Zeitpunkt um die Zeitverzögerung zu korrigieren und um das Energieübertragungsnetz (1) abhängig von dem Ereignis und dem korrigierten Zeitpunkt zu überprüfen, wobei die Information über das Ereignis von dem Messpunkt über mindestens einen weiteren Messpunkt zu den Steuermitteln ($E_0$) übertragen wird,

**dadurch gekennzeichnet, dass** der Messpunkt, der mindestens eine weitere Messpunkt und die Steuermittel ($E_0$) über Leitungen (5) miteinander verbunden sind, über welche die Information übertragen wird, und das System ausgestaltet ist, so dass die Bestimmung der Zeitverzögerung eine Bestimmung einer Laufzeit der Leitungen (5) und einer Verarbeitungszeit des mindestens einen weiteren Messpunkts, um die Information an dem jeweiligen Messpunkt zu erfassen und weiterzuleiten, umfasst.

**7.** System nach Anspruch 6,

**dadurch gekennzeichnet,**

**dass** das System zur Durchführung des Verfahrens nach einem der Ansprüche 1-2 ausgestaltet ist.

**8.** System zur Lokalisierung einer Fehlerstelle (6) in einem Energieübertragungskabel (1),

wobei das System Steuermittel ($E_0$) und mehrere Messeinheiten ($E_1$-$E_6$) umfasst,

wobei eine erste der Messeinheiten ($E_1$) mit einem ersten Messpunkt (4) an einem Ende des Energieübertragungskabels (1) und eine zweite der Messeinheiten ($E_6$) mit einem zweiten Messpunkt (4) an dem anderen Ende des Energieübertragungskabels (1) verbunden ist,

wobei die Messeinheiten ($E_1$-$E_6$) ausgestaltet sind, um jeweils einen Teilentladungspuls an dem mit der jeweiligen Messeinheit verbundenen Messpunkt (2; 4) in dem Energieübertragungskabel (1) zu erfassen,

wobei das System ausgestaltet ist,

um mittels der ersten Messeinheit ($E_1$) einen ersten Zeitpunkt zu erfassen, zu welchem ein bestimmter Teilentladungspuls an dem ersten Messpunkt (4) von der ersten Messeinheit ($E_1$) erfasst wird,

um mittels der zweiten Messeinheit ($E_6$) einen zweiten Zeitpunkt zu erfassen, zu welchem der bestimmte Teilentladungspuls an dem zweiten Messpunkt (4) von der zweiten Messeinheit ($E_6$) erfasst wird,

um mittels der Steuermittel ($E_0$) abhängig von dem ersten und dem zweiten Zeitpunkt eine Fehlerstelle (6) entlang des Energieübertragungskabels (1) zu bestimmen, an welcher der bestimmte Teilentladungspuls erzeugt wurde,

um mittels der Steuermittel ($E_0$) einen dritten Messpunkt und einen vierten Messpunkt derart zu bestimmen, dass der dritte und der vierte Messpunkt einen Abschnitt des Energieübertragungskabels (1) begrenzen, in welchem die Fehlerstelle (6) liegt und sich kein weiterer Messpunkt (2) befindet, welcher mit einer der Messeinheiten ($E_1$-$E_6$) verbindbar ist,

um mittels einer dritten der Messeinheiten, welche mit dem dritten Messpunkt verbunden ist, einen dritten Zeitpunkt zu erfassen, zu welchem ein weiterer bestimmter Teilentladungspuls an dem dritten Messpunkt von der dritten Messeinheit erfasst wird,

um mittels einer vierten der Messeinheiten, welche mit dem vierten Messpunkt verbunden ist, einen vierten Zeitpunkt zu erfassen, zu welchem der weitere bestimmte Teilentladungspuls an dem vierten Messpunkt von der vierten Messeinheit erfasst wird, und

um mittels der Steuermittel ($E_0$) abhängig von dem dritten und dem vierten Zeitpunkt die bestimmte Fehlerstelle (6) zu korrigieren,

wobei der erste Zeitpunkt, der zweite Zeitpunkt, der dritte Zeitpunkt und der vierte Zeitpunkt jeweils einem entsprechenden Zeitpunkt entsprechen, zu welchem eine Information über den entsprechenden Teilentladungspuls von Steuermitteln ($E_0$) erfasst wird, und

wobei das System zusätzlich ausgestaltet ist,

um eine jeweilige Zeitverzögerung, welche sich durch eine Übertragung der jeweiligen Information von dem entsprechenden Messpunkt ($E_1$-$E_6$) zu den Steuermitteln ($E_0$) ergibt, zu bestimmen, und

um den jeweiligen Zeitpunkt um die entsprechende Zeitverzögerung zu korrigieren,

wobei die Zeitverzögerung mit einem System nach einem der vorhergehenden Ansprüche bestimmt wird, welches mit dem System zur Lokalisierung einer Fehlerstelle kombiniert ist.

**9.** System nach Anspruch 8,

**dadurch gekennzeichnet,**

**dass** das System zur Durchführung des Verfahrens nach einem der Ansprüche 3-5 ausgestaltet ist.

**Claims**

1. A method for testing a power transmission network (1), comprising the following steps:

   detecting an event at a measurement point ($E_1$-$E_6$),
   transmitting an item of information about the event from the measurement point ($E_1$-$E_6$) to control means ($E_0$), and
   detecting a time at which the item of information about the event is detected by the control means ($E_0$),
   determining a time delay which is produced by a transmission of the item of information from the measurement point ($E_1$-$E_6$) to the control means ($E_0$),
   correcting the time by the time delay, and
   testing the power transmission network (1) depending on the event and the corrected time,
   wherein the item of information about the event is transmitted from the measurement point, via at least one further measurement point, to the control means ($E_0$),
   **characterized**
   **in that** the measurement point, the at least one further measurement point and the control means ($E_0$) are connected to one another via lines (5) via which the item of information is transmitted, and
   wherein determining the time delay comprises determining a run time of the lines (5) and a processing time of the at least one further measurement point in order to detect and to pass on the item of information at the respective measurement point.

2. The method as claimed in claim 1,
   **characterized**

   **in that** the measurement point, the at least one further measurement point and the control means ($E_0$) correspond to units which are connected in a daisy chain technique by means of the lines (5),
   **in that** the time delay $\Delta t$ is calculated by the following equation

   $$\Delta t = \sum_{i=0}^{x} \frac{(RXBW_i - RXFW_i)}{2} - \frac{(TXBW_{i+1} - TXFW_{i+1})}{2},$$

   where $RXBW_j$ corresponds to the time at which a specific data packet is received at the j-th unit in a backward direction,
   where $RXFW_j$ corresponds to the time at which the specific data packet is received at the j-th unit in a forward direction,
   where $TXBW_j$ corresponds to the time at which the specific data packet is sent to the j-th unit in the backward direction,
   where $TXFWj$ corresponds to the time at which the specific data packet is sent to the j-th unit in the forward direction,
   where x corresponds to the number of the at least one further measurement point, and
   where the control means ($E_0$) correspond to the 0-th unit and the measurement point corresponds to the 'x+1'-th unit ($E_1$-$E_6$).

3. A method for localizing a fault location (6) in a power transmission cable (1), comprising the following steps:

   detecting a first time at which a specific partial discharge pulse is detected in the power transmission cable (1) at a first measurement point ($E_1$) which is arranged at one end of the power transmission cable (1),
   detecting a second time at which the specific partial discharge pulse is detected in the power transmission cable (1) at a second measurement point ($E_6$) which is arranged at the other end of the power transmission cable (1),
   determining a fault location (6) along the power transmission cable (1), at which the specific partial discharge pulse was generated, depending on the first and the second time,
   determining a third and a fourth measurement point from a quantity of measurement points ($E_1$-$E_6$), which are arranged in the power transmission cable, in such a way that the third and the fourth measurement point delimit a section of the power transmission cable (1) in which the fault location (6) is situated and no further measurement points are located,
   detecting a third time at which a further specific partial discharge pulse is detected in the power transmission cable (1) at the third measurement point,
   detecting a fourth time at which the further specific partial discharge pulse is detected at the fourth measurement point, and

correcting the determined fault location (6) depending on the third and the fourth time,
wherein the first time, the second time, the third time and the fourth time each correspond to a corresponding time at which an item of information about the corresponding partial discharge pulse is detected by control means ($E_0$), and
wherein the method additionally comprises:

determining a respective time delay which is produced by a transmission of the respective item of information from the corresponding measurement point ($E_1$-$E_6$) to the control means ($E_0$), and
correcting the respective time by the corresponding time delay,
wherein the time delay is determined according to the method as claimed in one of the preceding claims.

4. The method as claimed in claim 3,
**characterized**

**in that** the fault location (6) is determined as a distance $l_f$ from the third measurement point using the following equation

$$l_f = \frac{v_{PD}}{2}(t_3 - t_4) + \frac{l}{2},$$

where $t_3$ corresponds to the third time, $t_4$ corresponds to the fourth time, $v_{PD}$ corresponds to the propagation speed of the partial discharge pulse on the power transmission cable (1) and I corresponds to the length of the section.

5. The method as claimed in claim 3 or 4,
**characterized**
**in that** the further specific partial discharge pulse corresponds to the specific partial discharge pulse, so that in each case the same partial discharge pulse is detected at the respective measurement point at the first, second, third and fourth time.

6. A system for testing a power transmission network (1),

wherein the system comprises control means ($E_0$) and a plurality of measurement units ($E_1$-$E_6$),
wherein each measurement unit ($E_1$-$E_6$), which is connected to a respective measurement point (2; 4) in the power transmission network (1), is configured in order to detect an event at the respective measurement point (2; 4) and in order to transmit an item of information about the event to the control means ($E_0$),
wherein the control means ($E_0$) are configured in order to detect a time at which the item of information about the event is detected by the control means ($E_0$),
wherein the system is configured in order to determine a time delay which is produced by a transmission of the item of information from the measurement unit, which detects the event, to the control means ($E_0$), and wherein the control means ($E_0$) are configured in order to correct the time by the time delay and in order to test the power transmission network (1) depending on the event and the corrected time,
wherein the item of information about the event is transmitted from the measurement point, via at least one further measurement point, to the control means ($E_0$),
**characterized in that**
the measurement point, the at least one further measurement point and the control means ($E_0$) are connected to one another via lines (5) via which the item of information is transmitted, and
the system is configured such that determining the time delay comprises determining a run time of the lines (5) and a processing time of the at least one further measurement point in order to detect and to pass on the item of information at the respective measurement point.

7. The system as claimed in claim 6,
**characterized**
**in that** the system is configured for carrying out the method as claimed in one of claims 1-2.

8. A system for localizing a fault location (6) in a power transmission cable (1),

wherein the system comprises control means ($E_0$) and a plurality of measurement units ($E_1$-$E_6$),

wherein a first of the measurement units ($E_1$) is connected to a first measurement point (4) at one end of the power transmission cable (1) and a second of the measurement units ($E_6$) is connected to a second measurement point (4) at the other end of the power transmission cable (1),

wherein the measurement units ($E_1$-$E_6$) are configured in order to detect in each case one partial discharge pulse at that measurement point (2; 4) which is connected to the respective measurement unit in the power transmission cable (1),

wherein the system is configured

in order to detect a first time at which the specific partial discharge pulse is detected at the first measurement point (4) by the first measurement unit ($E_1$) by means of the first measurement unit ($E_1$),

in order to detect a second time at which the specific partial discharge pulse is detected at the second measurement point (4) by the second measurement unit ($E_6$) by means of the second measurement unit ($E_6$),

in order to determine a fault location (6) along the power transmission cable (1), at which fault location the specific partial discharge pulse was produced, by means of the control means ($E_0$) depending on the first and the second time,

in order to determine a third measurement point and a fourth measurement point, by means of the control means ($E_0$), in such a way that the third and the fourth measurement point delimit a section of the power transmission cable (1) in which the fault location (6) is situated and no further measurement point (2) which can be connected to one of the measurement units ($E_1$-$E_6$) is located,

in order to detect a third time at which a further specific partial discharge pulse is detected at the third measurement point by the third measurement unit by means of a third of the measurement units which is connected to the third measurement point,

in order to detect a fourth time at which the further specific partial discharge pulse is detected at the fourth measurement point by the fourth measurement unit by means of a fourth of the measurement units which is connected to the fourth measurement point, and

in order to correct the determined fault location (6) by means of the control means ($E_0$) depending on the third and the fourth time,

wherein the first time, the second time, the third time and the fourth time each correspond to a corresponding time at which an item of information about the corresponding partial discharge pulse is detected by control means ($E_0$), and

wherein the system is additionally configured

in order to determine a respective time delay which is produced by a transmission of the respective item of information from the corresponding measurement point ($E_1$-$E_6$) to the control means ($E_0$), and

in order to correct the respective time by the corresponding time delay, wherein the time delay is determined with the system as claimed in one of the preceding claims, which is combined with the system for localizing a fault location.

9. The system as claimed in claim 8,
**characterized**
**in that** the system is configured for carrying out the method as claimed in one of claims 3-5.

**Revendications**

1. Procédé de vérification d'un réseau de transmission d'énergie (1), comprenant les étapes suivantes :

détection d'un événement à un point de mesure ($E_1$-$E_6$),

transmission d'une information sur l'événement du point de mesure ($E_1$-$E_6$) aux moyens de contrôle ($E_0$), et

détection d'un moment auquel l'information sur l'événement est détectée par les moyens de contrôle ($E_0$),

détermination d'un décalage temporel résultant d'une transmission de l'information du point de mesure ($E_1$-$E_6$) aux moyens de contrôle ($E_0$),

correction du moment avec le décalage temporel, et

vérification du réseau de transmission d'énergie (1) en fonction de l'événement et du moment corrigé,

dans lequel l'information sur l'événement est transmise du point de mesure aux moyens de contrôle ($E_0$) via au moins un autre point de mesure,

**caractérisée en ce que**

le point de mesure, l'au moins un autre point de mesure et les moyens de contrôle ($E_0$) sont reliés entre eux par des lignes (5) par lesquelles l'information est transmise, et

dans lequel la détermination du décalage temporel comprend une détermination d'un temps de fonctionnement des lignes (5) et d'un temps de traitement de l'au moins un autre point de mesure afin de détecter et de transférer l'information au point de mesure respectif.

2. Procédé selon la revendication 1,
   **caractérisé en ce que**

   le point de mesure, l'au moins un autre point de mesure et les moyens de contrôle ($E_0$) correspondent à des unités qui sont connectées au moyen des lignes (5) selon une technique de chaînage en série,
   que le décalage temporel LH est calculé par l'équation suivante

   $$\Delta t = \sum_{i=0}^{x} \frac{(RXBW_i - RXFW_i)}{2} - \frac{(TXBW_{i+1} - TXFW_{i+1})}{2},$$

   où $RXBW_j$ correspond au moment auquel un paquet particulier de données est reçu au niveau de la j-ième unité dans une direction inverse,
   où $RXFW_j$ correspond au moment auquel le paquet particulier de données est reçu au niveau de la j-ème unité dans une direction vers l'avant,
   où $TXBW_j$ correspond au moment auquel le paquet particulier de données est envoyé à la j-ième unité dans le sens inverse,
   où $TXFW_j$ correspond au moment auquel le paquet particulier de données est envoyé à la j-ième unité dans la direction vers l'avant,
   où x correspond au nombre d'au moins un autre point de mesure, et
   où les moyens de contrôle ($E_0$) correspondent à la 0-ème unité et le point de mesure à la 'x+1'-ème unité ($E_1$-$E_6$).

3. Procédé de localisation d'un point de défaillance (6) dans un câble de transmission d'énergie (1) comprenant les étapes suivantes :

   détection d'un premier moment auquel une impulsion de décharge partielle déterminée est détectée dans le câble de transmission d'énergie (1) en un premier point de mesure ($E_1$) situé à une extrémité du câble de transmission d'énergie (1),
   détection d'un deuxième moment auquel l'impulsion de décharge partielle déterminée est détectée dans le câble de transmission d'énergie (1) en un deuxième point de mesure ($E_6$) situé à l'autre extrémité du câble de transmission d'énergie (1),
   détermination d'un point de défaillance (6) le long du câble de transmission d'énergie (1) où l'impulsion de décharge partielle déterminée a été générée, en fonction du premier et du deuxième moment,
   détermination d'un troisième et d'un quatrième point de mesure à partir d'un ensemble de points de mesure ($E_1$-$E_6$) disposés dans le câble de transmission d'énergie de telle sorte que les troisième et quatrième points de mesure délimitent une section du câble de transmission d'énergie (1) dans laquelle se trouve le point de défaillance (6) et qu'aucun autre des points de mesure ne se trouve,
   détection d'un troisième moment auquel une autre impulsion de décharge partielle déterminée est détectée dans le câble de transmission d'énergie (1) au troisième point de mesure,
   détection d'un quatrième moment auquel l'autre impulsion de décharge partielle déterminée est détectée au quatrième point de mesure, et
   correction du point de défaillance déterminé (6) en fonction du troisième et du quatrième moments,
   dans lequel le premier moment, le deuxième moment, le troisième moment et le quatrième moment correspondent chacun à un moment correspondant auquel une information sur l'impulsion de décharge partielle correspondante est détectée par des moyens de contrôle ($E_0$), et
   le procédé comprenant en outre :

      détermination d'un décalage temporel respectif résultant d'une transmission de l'information respective du point de mesure correspondant ($E_1$-$E_6$) aux moyens de contrôle ($E_0$), et
      correction du moment respectif avec le décalage temporel correspondant,
      dans lequel le décalage temporel est déterminé selon un procédé selon l'une quelconque des revendications précédentes.

4. Procédé selon la revendication 3,
   **caractérisé en ce que**

le point de défaillance (6) est déterminé en tant que distance $l_f$ du troisième point de mesure à l'aide de l'équation suivante

$$l_f = \frac{v_{PD}}{2}(t_3 - t_4) + \frac{l}{2},$$

où $t_3$ correspond au troisième moment, $t_4$ au quatrième moment, $v_{PD}$ à la vitesse de propagation de l'impulsion de décharge partielle sur le câble de transmission d'énergie (1) et 1 à la longueur de la section.

5. Procédé selon la revendication 3 ou 4,
**caractérisé en ce que**
l'autre impulsion de décharge partielle déterminée correspond à l'impulsion de décharge partielle déterminée, de sorte qu'aux premier, deuxième, troisième et quatrième moments, la même impulsion de décharge partielle est respectivement détectée au point de mesure respectif.

6. Système de vérification d'un réseau de transmission d'énergie (1),

dans lequel le système comprend des moyens de contrôle ($E_0$) et plusieurs unités de mesure ($E_1$-$E_6$),
dans lequel chaque unité de mesure ($E_1$-$E_6$) connectée à un point de mesure respectif (2 ; 4) dans le réseau de transmission d'énergie (1) est conçue pour détecter un événement au point de mesure respectif (2 ; 4) et pour transmettre une information sur l'événement aux moyens de contrôle ($E_0$), les moyens de contrôle ($E_0$) étant conçus pour détecter un moment auquel l'information sur l'événement est détectée par les moyens de contrôle ($E_0$),
dans lequel le système est conçu pour déterminer un décalage temporel résultant d'une transmission de l'information de l'unité de mesure détectant l'événement aux moyens de contrôle ($E_0$) et que les moyens de contrôle ($E_0$) sont conçus pour corriger le moment avec le décalage temporel et pour vérifier le réseau de transmission d'énergie (1) en fonction de l'événement et du moment corrigé,
dans lequel l'information sur l'événement est transmise du point de mesure aux moyens de contrôle ($E_0$) via au moins un autre point de mesure,
**caractérisée en ce que**
le point de mesure, l'au moins un autre point de mesure et les moyens de contrôle ($E_0$) sont reliés entre eux par des lignes (5) par lesquelles l'information est transmise, et
le système est conçu de sorte que la détermination du décalage temporel comprend une détermination d'un temps de fonctionnement des lignes (5) et d'un temps de traitement de l'au moins un autre point de mesure afin de détecter et de transférer l'information au point de mesure respectif.

7. _ Système selon la revendication 6,
**caractérisé en ce que**
le système est conçu pour la mise en œuvre du procédé selon l'une des revendications 1-2.

8. Système de localisation d'un point de défaillance (6) dans un câble de transmission d'énergie (1),

dans lequel le système comprend des moyens de contrôle ($E_0$) et plusieurs unités de mesure ($E_1$-$E_6$),
dans lequel une première des unités de mesure ($E_1$) est connectée à un premier point de mesure (4) à une extrémité du câble de transmission d'énergie (1) et une deuxième des unités de mesure ($E_6$) est connectée à un deuxième point de mesure (4) à l'autre extrémité du câble de transmission d'énergie (1),
dans lequel les unités de mesure ($E_1$-$E_6$) sont conçues pour détecter respectivement une impulsion de décharge partielle au point de mesure (2 ; 4) connecté à l'unité de mesure respective dans le câble de transmission d'énergie (1),
dans lequel le système est conçu,
pour détecter, au moyen de la première unité de mesure ($E_1$), un premier moment auquel une impulsion de décharge partielle déterminée est détectée au premier point de mesure (4) par la première unité de mesure ($E_1$),
pour détecter, au moyen de la deuxième unité de mesure ($E_6$), un deuxième moment auquel l'impulsion de décharge partielle déterminée est détectée au deuxième point de mesure (4) par la deuxième unité de mesure ($E_6$),
pour déterminer, à l'aide des moyens de contrôle ($E_0$), en fonction des premier et deuxième moments, un point de défaillance (6) le long du câble de transmission d'énergie (1) où l'impulsion de décharge partielle déterminée a été générée,

pour déterminer, à l'aide des moyens de contrôle ($E_0$), un troisième point de mesure et un quatrième point de mesure de manière à ce que les troisième et quatrième points de mesure délimitent une section du câble de transmission d'énergie (1) dans laquelle se trouve le point de défaillance (6) et qu'il n'y ait pas d'autre point de mesure (2) pouvant être connecté à l'une des unités de mesure ($E_1$-$E_6$),

pour détecter un troisième moment au moyen d'une troisième des unités de mesure, qui est reliée au troisième point de mesure, auquel une autre impulsion de décharge partielle déterminée est détectée au troisième point de mesure par la troisième unité de mesure,

pour détecter un quatrième moment au moyen d'une quatrième des unités de mesure, qui est reliée au quatrième point de mesure, auquel l'autre impulsion de décharge partielle déterminée est détectée au quatrième point de mesure par la quatrième unité de mesure, et

pour corriger le point de défaillance déterminé (6) à l'aide des moyens de contrôle ($E_0$) en fonction des troisième et quatrième moments,

dans lequel le premier moment, le deuxième moment, le troisième moment et le quatrième moment correspondent chacun à un moment correspondant auquel une information sur l'impulsion de décharge partielle correspondante est détectée par des moyens de contrôle ($E_0$), et

dans lequel le système est conçu en plus,

pour déterminer un décalage temporel respectif résultant d'une transmission de l'information respective du point de mesure correspondant ($E_1$-$E_6$) aux moyens de contrôle ($E_0$), et

pour corriger le moment respectif avec le décalage temporel correspondant,

dans lequel le décalage temporel est déterminé avec un système selon l'une quelconque des revendications précédentes, qui est combiné avec le système de localisation d'un point de défaillance.

9. Système selon la revendication 8,
**caractérisé en ce que**
le système est conçu pour la mise en œuvre du procédé selon l'une des revendications 3-5.

Fig. 1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- CN 104049179 A
- DE 102014222662 A1
- US 2009289637 A1
- US 2014074414 A1

**In der Beschreibung aufgeführte Nicht-Patentliteratur**

- **I.V. BARBURAS**. Detecting The Fault Location Using Traveling Wave. *6th International Conference on Modern Power Systems*, 18 May 2015, 23-26